# EUROPEAN PATENT SPECIFICATION

(11) **EP 2 707 958 B1**
(45) Date of publication and mention of the grant of the patent: **18.11.2015**
(21) Application number: 12720172.1
(22) Date of filing: 09.05.2012
(51) Int. Cl.: H03K 17/16, H03K 17/28, H01H 9/56

(54) **POINT-ON-WAVE CONTROLLER WITH AT LEAST THREE MONITORING INPUTS**
ABB-STEUERGERÄT MIT MINDESTENS DREI ÜBERWACHUNGSEINGABEN
CONTRÔLEUR POINT SUR ONDE DOTÉ D'AU MOINS TROIS ENTRÉES DE CONTRÔLE

(30) Priority: 09.05.2011 EP 11165285
(43) Date of publication of application: 19.03.2014
(73) Proprietor: ABB Technology AG, 8050 Zürich (CH)
(72) Inventor: STANEK, Michael, CH-5412 Gebenstorf (CH); TALLURI, Anil, Bangalore 560001 (IN)
(74) Representative: ABB Patent Attorneys
(86) International application number: PCT/EP2012/058533
(87) International publication number: WO 2012/152829

(56) References cited:
- EP-A2- 2 237 296
- US-A1- 2008 211 317

## Description

### Technical Field

The present invention relates to a point-on-wave controller device and method for controlling the operation of a circuit breaker device, particularly in AC power transmission networks, and to a bay in a power transmission network comprising a circuit breaker device and a point-on-wave controller.

### Introduction and Background Art

In order to minimize switching transients during circuit breaker (CB) operations in power transmission networks, controlled switching (point-on-wave (POW) control, also called "synchronous switching") of the CB is a state-of-the-art technique. In short, it is to delay the CB operation in such a way that contact touch/separation and/or start/stop of current flow will occur at a point in time that is well suited for the CB, the switched load, and/or the network. This point in time is usually chosen as a specific phase angle of the primary voltage or current in the network. E.g. for capacitive load, a well suited energization instant is usually at voltage zero in each phase.

For this purpose, the POW controller acquires an "image" (monitoring signal) of the primary voltage from a monitoring device, such as a voltage sensor, connected to an appropriate analog monitoring interface. The monitoring signals, on which the POW controller bases its calculations, are called reference signals. One or more reference signals can be used; they are usually single-phase or three-phase.

However, the properties of the switched load and therefore the switching strategy or the switching instant itself may change between switching operations. For example, a transmission line may be operated uncompensated or shunt-compensated, or the neutral point of a shunt reactor may be grounded or ungrounded.

Furthermore, in certain bays with a 1 1/2 CB layout, a central CB may energize the load on either side, depending on which side of the CB is energized prior to the "close" command to the CB via the POW controller.

EP 1351267 describes automatic selection of the appropriate reference voltage signal and the associated controlled switching strategy, based on the presence or absence of one or another analog monitoring signal.

EP 2 237 296 A2 discloses a point-on-wave controller which takes into account state quantities of the controlled circuit breaker.

EP 2 182 535 A2 discloses a switching controller and switching control system for a plurality of circuit breakers which takes into account state quantities of the controlled circuit breakers.

All the described implementation have the disadvantage, however, that appropriate switching strategies may not be achieved in all cases, e.g. not in the case of two loads in a 1 1/2 CB layout with charging properties of one or both loads.

### Disclosure of the Invention

Hence it is a general objective of the present invention to provide a device and method for achieving a better circuit breaker operation strategy for a plurality of different switching configurations. It is a further objective of the invention to provide a bay comprising an improved POW controller that implements such a method.

These objectives are achieved by the devices and method of the independent claims. Embodiments are given e.g. by dependent claims and claim combinations.

Accordingly, in a first embodiment of the current invention, a point-on-wave controller controls the operation of a circuit breaker device that is used, e.g., in an AC high-voltage power transmission network. The POW controller comprises at least three monitoring interfaces, as part of a parameter input interface, to acquire operating parameters of the power transmission network via analog and optionally digital monitoring signals from analog and digital monitoring devices. The analog monitoring interfaces (e.g. monitoring interfaces for analog voltage signals) of the POW controller are connectable to voltage sensors as analog monitoring devices such that a voltage in the power transmission network is monitored as a part of its operating parameters. The digital monitoring interface or interfaces of the POW controller are connectable to, e.g., auxiliary contacts or position sensors as digital monitoring device or devices of at least one additional switch such that a binary state of the additional switch in the power transmission network can be monitored as a part of the network's operating parameters. The additional switch is different from the circuit breaker device controlled by the point-on-wave controller. The binary state is indicative of a configuration in the power transmission network. The configuration in the power transmission network is a current configuration of a load, e.g. of a power transformer or of a transmission line or a grounding state of a neutral point of a reactor. Thus, intentional changes of the network configuration or topology changes may be communicated by one or more binary signal (s) (digital monitoring signal(s)) to the POW controller, which can then choose the best controlled switching strategy for the circuit breaker to be used in the particular situation of the power transmission network.

In addition, a suitable monitoring device may be absent at the ideal measurement location, and the reference signal(s) must be taken from other measurement points. Depending on the current network configuration (in particular status of switchgear(s), i.e. circuit breaker devices, or additional switches), different monitoring signals may be used.

At least three monitoring signals from different locations (i.e. not only three phases at one location) in a single-line diagram of the power transmission network are measured, specifically at least one single-phase or three-phase voltage signal and optionally (a) binary state(s) (open/closed) of one or more additional switches (such as e.g. disconnect switches or earthing switches), which are different from the circuit breaker device controlled by the POW controller in the power transmission network.

In an embodiment, the at least one additional switch is positioned on a load side and/or on a source side of the circuit breaker device.

In another embodiment, the reference voltage sensor for point-on-wave controlled switching of the circuit breaker device is not permanently connected to the circuit breaker device.

In another embodiment, the binary state of said additional switch is used to determine a network topology on a load side and/or source side of the circuit breaker device, and/or is used to select at least one voltage sensor to be useful as a reference voltage sensor for the point-on-wave controlled switching of the circuit breaker device.

In another embodiment, the additional switch is a switch for connecting and disconnecting a shunt reactor to a transmission line.

In another embodiment, the additional switch is a switch for connecting and disconnecting a neutral point of a three-phase primary device, in particular a reactor and/or a transformer, to earth.

In another embodiment, the additional switch is a switch for connecting and disconnecting a voltage sensor to a source side of the circuit breaker, in particular to a busbar, for determining whether the signal from said voltage sensor is indicative of a voltage applied to the circuit breaker device.

In another embodiment, the two voltages are used to determine a source side and a load side of the circuit breaker device, and the digital monitoring signal indicative of said binary state of the additional switch on the load side is used to calculate or select the operation strategy of said circuit breaker device.

Furthermore, in addition to said parameter input interface, the point-on-wave controller comprises a command input interface which is adapted to receive an external switching command from a switching command issuing device, advantageously a bay controller or a protection relay, and a command output interface which is adapted to issue the actual circuit breaker switching command to the circuit breaker device at the calculated instant in time. The external switching command is usually not synchronized to the operating parameters of the power transmission network, but occurs randomly in time or - in other words - unsynchronized to the network, e.g. at a random phase angle of the voltage or current in the power transmission network. The purpose of the point-on-wave controller is now to achieve a better operation strategy for said circuit breaker device, i.e. to achieve a network synchronized switching of the CB device. By arranging at least three monitoring interfaces in the parameter input interface of the point-on-wave controller, additional information about the operating parameters of the power transmission network is obtained via said monitoring signals from said monitoring devices and a better operation strategy for the controlled circuit breaker device can be calculated by a control unit in the POW controller depending on said operating parameters. This may generally be done before or after receiving an external switching command from said switching command issuing device through said command input interface of the POW controller. At the right instant the POW controller then issues the actual circuit breaker switching command to the circuit breaker device via said command output interface.

Different configurations of said monitoring interfaces are advantageous for different applications. E.g. for a substation with a double busbar arrangement and no busbar monitoring devices, a POW controller with two analog monitoring interfaces and one digital monitoring interface is advantageously used, if a logic circuit can be utilized to combine binary, monitoring signals. Otherwise, additional digital monitoring interfaces are advantageously arranged on the POW controller to receive the binary monitoring signals. If further voltage signals shall be monitored, e.g. from additional components like power transformers, additional analog monitoring interfaces might advantageously be arranged on the POW controller. In special 1 1/2 CB layouts, at least three analog monitoring interfaces are advantageously arranged on the POW controller with optional additional digital monitoring interfaces.

The control unit in the POW controller calculates the operation strategy for the CB device by advantageously introducing a calculated time delay between the external switching command from the switching command issuing device to the POW controller and the actual CB switching command from the POW controller to the CB device. The duration of this calculated time delay is dependent on the monitored operating parameters of the power transmission network, e.g. the phase of the voltage and/or the topology of the network, and it is computed in a control unit in the POW controller. Advantageously, said calculated time delay can be modified dynamically, depending on CB state information that can - as part of said operating parameters of the power transmission network - be gathered from said CB device by the POW controller.

In embodiments, prototypes of operating strategies are pre-stored in a memory in the control unit of the point-on-wave controller and are selected based on the operating parameters of the power transmission network. Thus, only some parameters like the calculated time delay need to be computed by the control unit of the POW controller.

In another embodiment, the calculation of the operation strategy for the circuit breaker device comprises a selection of at least one operating parameter of said power transmission network. This selected operating parameter is then used as a reference signal for the switching operation of said circuit breaker device. The monitoring signals, on which the POW controller bases its calculations, are called reference signals. One or more reference signals can be used; they are usually single-phase or three-phase.

In general, the current invention can be implemented as device or method. Furthermore, the current invention can also relate to a bay in a power transmission network comprising at least one of said point-on-wave controllers and at least one circuit breaker device and at least one additional switch different from the circuit breaker device, which additional switch has a binary state indicative of a configuration in the network that is relevant for synchronous switching of the circuit breaker device.

### Brief Description of the Drawings

The invention will be better understood and objects other than those set forth above will become apparent when consideration is given to the following detailed description thereof. Such description makes reference to the annexed drawings, wherein:
Fig. 1 shows a first embodiment of the invention and a power transmission network with a CB device,
Fig. 2 schematically shows a possible operating principle of a POW controller,
Fig. 3 shows a second embodiment of a POW controller and a CB device,
Fig. 4 shows a third embodiment of the invention and a power transmission network with a CB device,
Fig. 5 shows a fourth embodiment of the invention and a power transmission network with a CB device,
Fig. 6 shows a fifth embodiment of the invention and a power transmission network with a CB device.

### Modes for Carrying Out the Invention

### Summary:

A point-on-wave controller for network synchronous switching of a circuit breaker device in an AC power transmission network is disclosed which comprises at least three monitoring interfaces. A plurality of operating parameters of said power transmission network is used for selecting the reference signal(s) for said point-on-wave controller and during the calculation of an improved operation strategy for said circuit breaker device.

### Definitions:

A poirit-on-wave controller 1 is a controller device for a circuit breaker device 2a, 2b, 2c in an AC power transmission network 3 that - usually after receiving an external switching command 41 from a switching command issuing device 40 - determines a suitable operation strategy and issues an actual circuit breaker switching command for the actual execution of a switching action by said circuit breaker device 2a, 2b, 2c. By, e.g., delaying said external switching command 41 by a certain calculated time delay 45, switching at a certain phase 47a, 47b, 47c, 48a, 48b, 52a, 52b of an operating parameter of the network, e.g. a voltage in the power transmission network 3, is achieved.

In general, calculation of an operation strategy for network-synchronous switching shall also encompass selection of a predetermined or otherwise derived operation strategy for network-synchronous switching.

The term "high-voltage" relates to voltages larger than 1 kV, in particular larger than 72 kV.

The term 1 1/2 CB layout refers to a configuration of a part of a power substation, e.g. a diameter, wherein for example three CB devices 2a, 2b, 2c are used to protect or switch two loads, e.g. a power transformer 96 and a transmission line 97. Thus, on average there are 1.5 CB devices for each load, hence the name 1 1/2 CB layout.

A bay is that part of a substation within which the switchgear and control gear relating to a given circuit are contained. Usually it comprises a circuit breaker with its associated disconnectors, earthing switches, instrument transformers, and control & protection equipment.

A single-line diagram is a simplified notation for representing a three-phase power system. Instead of representing each of three phases with a separate line or terminal, only one conductor is represented. (From: http://en.wikipedia.org/wiki/Single-line_diagram as of April 13, 2011). An analog three-phase voltage monitoring signal from one location in the single line diagram of the power transmission network is referred to as one analog monitoring signal, i.e. the individual voltage signals from the three phases are not counted separately. In other words, if two analog voltage monitoring signals are mentioned, it is assumed that these signals are measured at different locations in the power transmission network, not at the same location for individual phases.

### Description of the Figures:

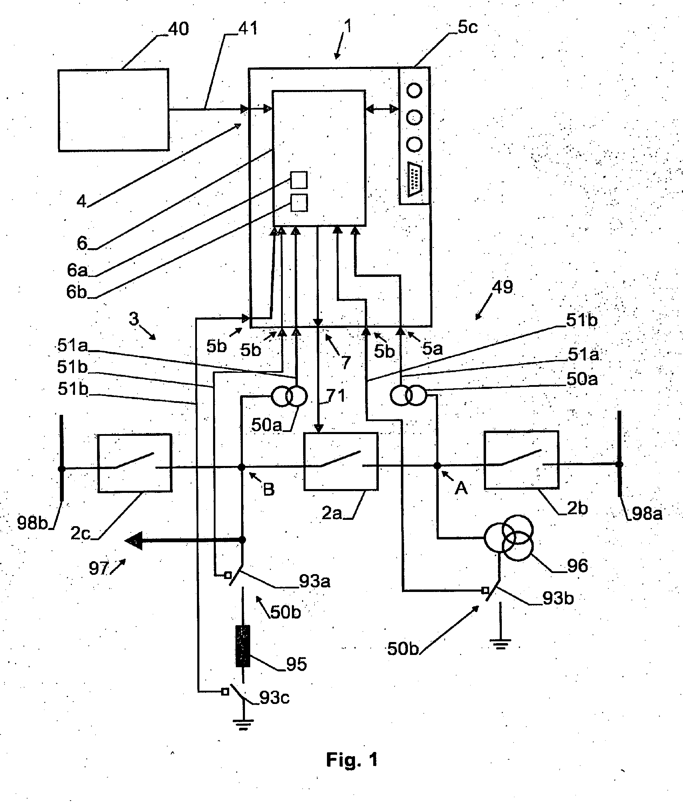

Fig. 1 shows the single-line diagram of a POW controller 1 for a CB device 2a in a network layout in 1 1/2 CB configuration, wherein a transmission line 97 and a power transformer 96 are switched between two bus bars 98a and 98b. The transmission line 97 may be operated uncompensated or shunt-compensated (by reactor 95), i.e. with the corresponding additional switch 93a open or closed. On the power transformer 96, the neutral point of the primary winding may be grounded (i.e. with the corresponding additional switch 93b closed) or ungrounded (i.e. with the corresponding additional switch 93b open). For effective controlled opening and/or cloning of the circuit breaker device 2a in any possible configuration, the POW controller 1, which controls the CB device 2a, must know - at the latest after receiving an external switching command 41 from a switching command issuing device 40 via the POW controller's 1 command input interface 4, but prior to issuing an actual circuit breaker switching command 71 to the CB device 2a via its command output interface 7 -
   * whether to energize the transmission line 97 or the power transformer 96, and
   * additionally the current configuration of the respective load, i.e. the binary status of the additional switches 93a or 93b, respectively.

For determining which element to energize, the POW controller 1 monitors the voltage signals at the power transformer 96 (location A) and at the transmission line 97 (location B) via its parameter input interface 5a, 5b, 5c, specifically via the analog monitoring interfaces 5a (of the parameter input interface 5a, 5b, 5c) that are connected to the monitoring devices 50a (e.g. voltage sensors in this case) in the power transmission network 3. Therefore, in this embodiment, said analog monitoring interfaces 5a are adapted to measure an analog monitoring signal 51a, e.g. a single- or three-phase-voltage signal originating from the monitoring devices 50a. Depending on the presence or absence of voltages in locations A and B, the POW controller 1 decides which load to energize: If a nonzero voltage is present at location B, then the power transformer 96 is to be energized and the analog monitoring signal 51a from location B is used as reference. If a nonzero voltage is present at location A, then the transmission line 97 is to be energized and the analog monitoring signal 51a from location A is used as reference.

After having determined which load to energize, the POW controller 1 additionally shall determine the configuration of the respective load because a good operating strategy is dependent on this configuration. To know about the current configuration of the respective load, i.e. in this example the status of the additional switch 93a or 93b, respectively, the digital monitoring interfaces 5b of the POW controller 1 are connected to monitoring devices 50b in the additional switches 93a and 93b. Specifically, auxiliary contacts or position sensors are arranged in the additional switches 93a or 93b and report the state, in particular binary state, of the respective additional switch 93a or 93b to the POW controller 1 via digital monitoring signals 51b. These auxiliary contacts or position sensors in the additional switches 93a and 93b therefore are here acting as binary or digital monitoring devices 50b. Depending on the thus determinted configuration of the load, the POW controller 1 can now calculate a well suited operation strategy for the CB device 2a.

If the POW controller 1 now receives a "close" command for the CB device 2a via an external switching command 41 from the switching command issuing device 40, it first checks which load is to be energized by monitoring the analog voltages at the locations A and B as discussed above. With that information, it then determines the current configuration of the respective load from the associated status of the additional switch. 93a or 93b. If the power transformer 96 is to be energized, a good energization or operation strategy depends on whether or not the neutral point of the primary winding is currently grounded. E.g. if the neutral point of the primary winding is grounded, a good operation strategy would be to energize the first breaker pole at its phase-ground voltage peak, the other two a quarter cycle later; otherwise two breaker poles would be closed simultaneously at a phase-phase voltage peak and the third one a quarter cycle later. If the transmission line 97 is to be energized and the additional switch 93a is open (i.e. the load is uncompensated), a good operation strategy would be to close each breaker pole (current start) at its individual phase-ground voltage zero, otherwise at voltage peak. Furthermore, optional additional information about further operating parameters 49 of the power transmission network 3 (e.g. whether or not the neutral point of the reactor 95 is grounded or not, i.e. the binary state of the additional switch 93c) can also be included in the calculation of a well suited operation strategy for the circuit breaker device 2a. The calculation of the operation strategy itself is performed by a control unit 6 (connected to all the interfaces) of the POW controller 1, which comprises a central processing unit (CPU) 6b and a memory 6a that is connected to the CPU 6b and in which different operation strategy prototypes are advantageously pre-stored. In such a case the POW controller 1 selects the appropriate operation strategy prototype depending on the combination of operating parameters 49 in the power transmission network 3 and modifies it (e.g. by adapting a calculated time delay 45 as discussed below) to achieve a well suited operation strategy for the CB device 2a.

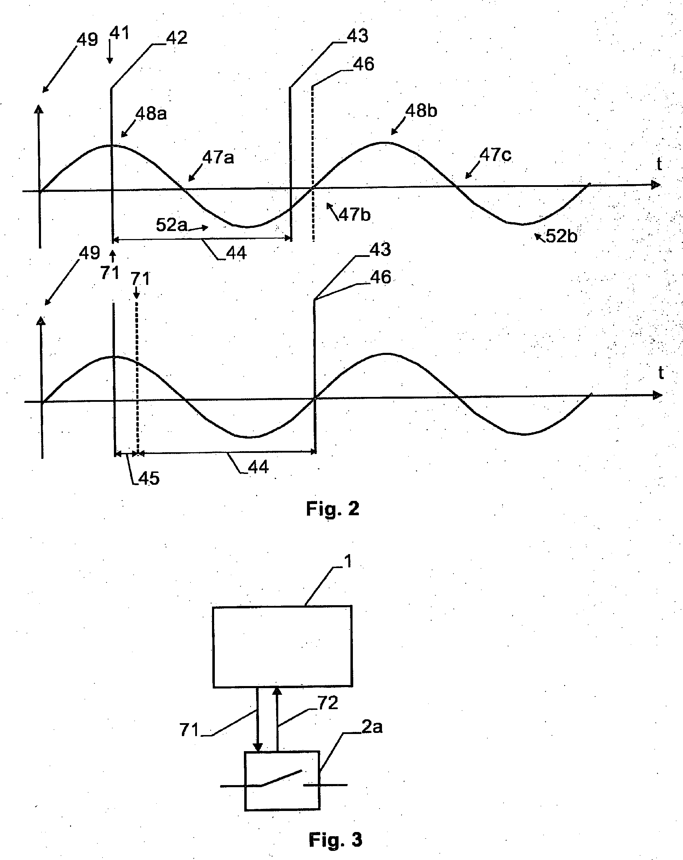

Depending on the operating parameters 49 (including the monitoring signals 51a, 51b), the control unit 6 of the POW controller 1 calculates or selects a suitable operation strategy for the circuit breaker device 2a, 2b, 2c, i.e. a well suited energization instant (in each phase) of the respective load. For example, as it is further illustrated in Fig. 2, at a random time 42 of the external switching command 41 the operating parameters 49 (e.g. including voltage signals 51a in said power transmission network 3) are monitored as described above. Furthermore, the POW controller 1 knows about the CB operating time 44, i.e. the time the CB device 2a, 2b, 2c needs to execute the actual switching action. This value is usually stored in the memory 6a of the POW controller 1 at the time of engineering or commissioning. Alternatively, it may be measured by the POW controller 1 itself, e.g. during commissioning, and may be stored in the memory 6a.

If the external switching command 41 was passed on to the CB device 2a, 2b, 2c instantly (in form of a simultaneous circuit breaker switching command 71), the actual switching instant 43 of the CB device 2a, 2b, 2c would normally not occur at the desired switching instant 46 for the CB device 2a, 2b, 2c, e.g. at a zero crossing 47a, 47b, 47c or at a positive peak 48a, 48b, or at a negative peak 52a, 52b of said operating parameter 49 (as illustrated in the top panel of Fig. 2). Therefore, the signal of the operating parameter 49, i.e. the reference signal, is extrapolated by the POW controller 1 and - depending on the selected or calculated operation strategy and in knowledge of the CB operating time 44 - a calculate time delay 45 is introduced, after which a circuit breaker switching command 71 is issued via the POW controller's command output interface 7. Then, the actual switching instant 43 of the CB device 2a, 2b, 2c coincides with the desired switching instant 46 of the CB device 2a, 2b, 2c, as it is shown in the lower panel of Fig. 2 for the example of a zero crossing 47b.

Furthermore, as it is illustrated in Fig. 3, said operating parameters 49 could - in addition to the information about the power transmission network 3 - advantageously comprise CB state information 72 about the circuit breaker device 2a, 2b, 2c itself. An example would be status information about the CB device 2a, 2b, 2c that could, e.g., influence the CB operating time 44. A good knowledge about this CB operating time 44 is needed by the POW controller 1, however, to calculate a well suited operation' strategy for the CB device 2a, 2b, 2c and to achieve a precisely timed switching performance. Thus, by gathering CB state information 72 about the device 2a, 2b, 2c and correcting the CB operating time 44 dependent on this CB state information 72, a better operation strategy for the CB device 2a, 2b, 2c can be achieved.

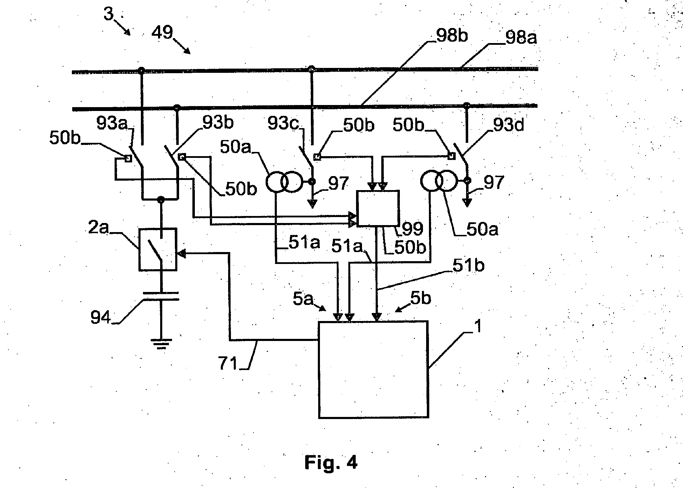

Fig. 4 shows another embodiment of the current invention (single-line diagram) where the POW controller 1 controls a CB device 2a and comprises two analog monitoring interfaces 5a and one digital monitoring interface 5b. Here, the POW controller 1 is connected to monitoring devices 50a (e.g. voltage sensors) on two transmission lines 97 in different bays via its parameter input interface 5a, 5b, 5c, specifically the analog monitoring interfaces 5a. Analog monitoring signals 51a from the monitoring devices 50a report operating parameters 49 of the power transmission network 3 to the POW controller 1. Furthermore, the digital monitoring interface 5b of the POW controller 1 is connected to a logic circuit 99 (which can also be implemented as logic combination in the wiring) that tells the POW controller 1 by a single binary signal whether to use the left or the right monitoring device 50a (or the left or right analog monitoring signal 51a, respectively) as reference signal for calculating an operation strategy for controlled switching of the capacitor 94 by the CB device 2a. This is achieved by feeding information about the CB states of the circuit breakers/switches 93a, 93b, 93c, 93d (e.g. from auxiliary contacts in these switching elements as discussed above) to said logic circuit 99, which itself sends a single binary signal 51b to the digital monitoring interface 5b of the parameter input interface 5a, 5b, 5c of the POW controller 1. Therefore, said logic circuit 99 acts as digital monitoring device 50b for the logical combination of the states, in particular binary states, of said additional switching elements 93a, 93b, 93c, 93d.

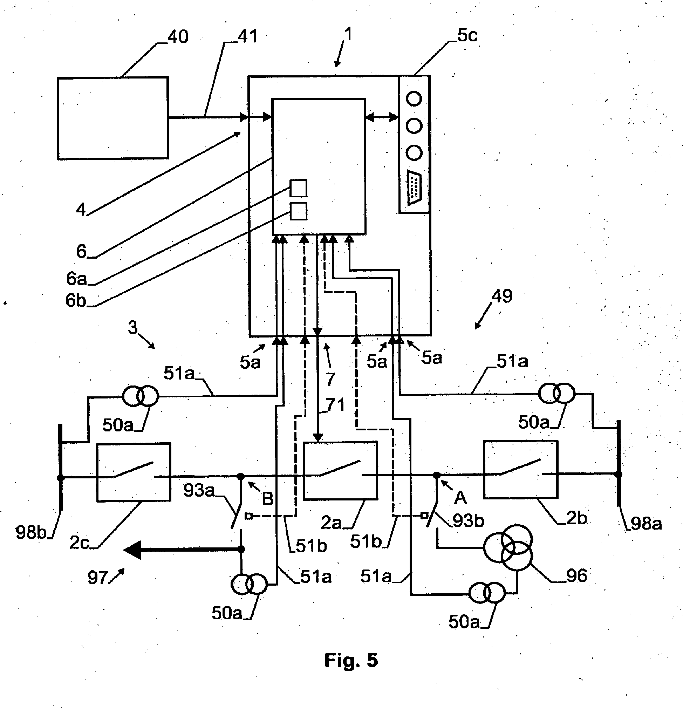

In another embodiment of the invention according to Fig. 5 (single-line diagram), control unit 6 of the POW controller 1 calculates the operation strategy for the CB device 2a, 2b, 2c based on operating parameters 49 of the power transmission network 3. In this embodiment the POW controller 1, specifically its parameter input interface 5a, 5b, 5c, comprises three or more analog monitoring interfaces 5a to determine a well suited operation strategy for the CB device 2a. Fig. 5 shows the single-line diagram of a POW controller 1 for a CB device 2a in a network layout in 1 1/2 CB configuration, where a transmission line 97 and a power transformer. 96 are switched between two bus bars 98a and 98b. As discussed above, prior to issuing an actual circuit breaker switching command 71 to the CB device 2a via its command output interface 7, the POW controller needs to know whether to energize the transmission line 97 or the power transformer 96. To gather this knowledge, suitable locations for measuring the presence or absence of a nonzero voltage are locations A and B. However, monitoring devices 50a such as voltage sensors are not present in these locations A and B in the embodiment of Fig. 5. Thus, without further information the POW controller 1 cannot be sure which monitoring signal 51a to use as a reference signal. In this example, monitoring devices 50a are connected to the bus bars 98a and 98b, to a secondary winding of the power transformer 96, and to the transmission line 97. These analog monitoring devices 50a transmit analog monitoring signals 51a to the analog monitoring interfaces 5a of the parameter input interface 5a, 5b, 5c of the POW controller 1. Depending on these operation parameters 49 of the power transmission network 3 the POW controller 1 decides automatically which of these analog monitoring signals 51a to use as reference signal(s) and for calculating a well suited operation strategy for the CB device 2a. In this embodiment, the knowledge of absence or presence of voltage in locations A and B may also be an exemplary or implicit representation of measuring a binary state of at least one additional switch 93a, 93b in said power transmission network 3, which additional switch 93a, 93b is different from the circuit breaker device 2a, and wherein said monitoring signals 51a, 51b further comprise at least one digital monitoring signal 51b indicative of said binary state of said additional switch 93a, 93b.

The selection of reference signal(s) may have further consequences on internal signal processing. E.g., the monitoring signal 51a from the monitoring device 50a on the power transformer's 96 secondary winding may be single-phase and phase shifted with respect to the signal on the primary side, whereas the monitoring signal 51a from the monitoring device 50a on the transmission line 97 is three-phase and in phase with the single-phase monitoring signals 51a from the monitoring devices 50a on the busbars 98a, 98b. Such differences can be taken care of automatically.

In addition to the (at least three) analog monitoring signals, optional explicit binary signals 51b (dashed line in Fig. 5) that carry status information about the binary state of any of the switches 93a, 93b can additionally be used to refine the selection process.

Furthermore, additional properties of the analog monitoring signals 51a, such as amplitude or fundamental frequency, may also be included in the selection of the reference signal(s) and in calculation of a well suited operation strategy for the CB device 2a, e.g. to achieve CB operation in a beat minimum of the voltage across the circuit breaker.

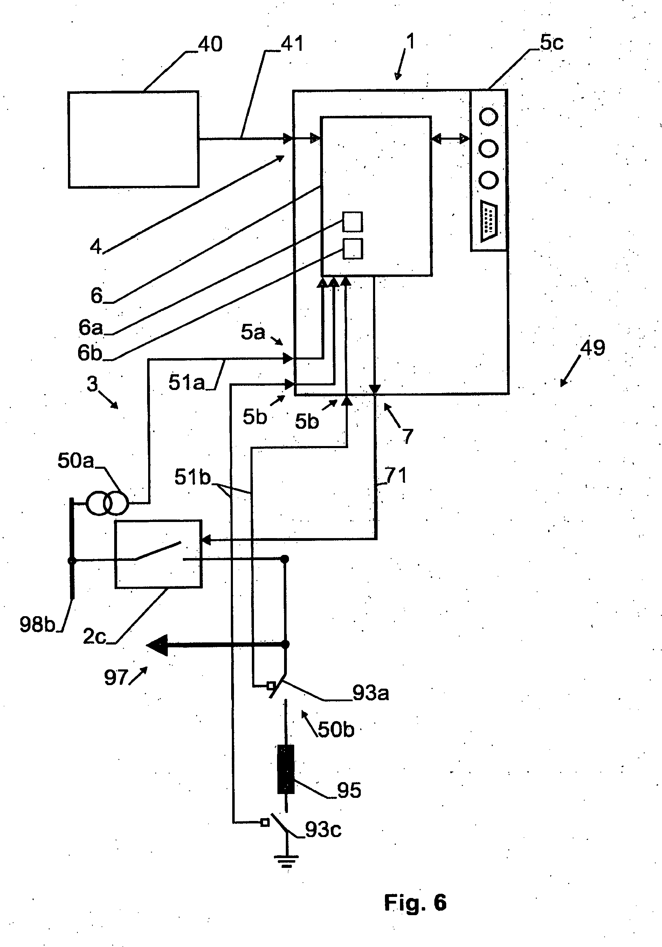

In another embodiment of the invention as shown in Fig. 6 (single-line diagram) a POW controller 1 controls a CB device 2c in a network 3 where a transmission line 97 is switched to a bus bar 98b. The transmission line 97 may be operated uncompensated or shunt-compensated (by reactor 95), i.e. with the corresponding additional switch 93a open or closed. Furthermore, additional information, e.g. about whether or not the neutral point of the reactor 95 is grounded or not (i.e. the binary state of switch 93c) is useful for the calculation of a well suited operation strategy for the circuit breaker device 2c. An analog monitoring signal 51a from the monitoring device 50a reports further operating parameters 49 of the power transmission network 3 to the POW controller 1, specifically the voltage on the bus bar 98b, which is used as reference signal for calculating the operation strategy for controlled switching of the circuit breaker device 2c. In summary, in this embodiment two digital monitoring interfaces 5b and one analoge monitoring interface 5a are arranged on the POW controller 1 and receive respective operating parameters 49 of the power transmission network 3.

### Notes:

Alternatively to reading out the operation parameters 49 of the power transmission network 3 via the parameter input interface 5a, 5b, 5c after an external switching command 41 has been issued, the monitoring operations can also be performed continuously, i.e. also at times when no external switching command 41 has been received by the POW controller 1. Alternatively, they can be performed at a fixed update rate, e.g. at several times for each (sinusoidal) voltage cycle. Other rates or combinations are possible as well.

Usually, a single POW controller 1 controls a single CB device 2a, 2b, 2c (for one or three phases). If multiple CB devices 2a, 2b, 2c are referred to in this context, it is only to illustrate that similar operation strategies are to be applied to all CB devices 2a, 2b, 2c and their respective POW controllers. However, one POW controller 1 could also control several CBs 2a, 2b, 2c.

The term "operation strategy prototype" refers to an operation strategy that can be adapted to certain boundary conditions of said operating parameters 49, e.g. to perform a failsafe operation in the case of malfunctioning monitoring devices 50a, 50b, or to modify a CB operating time 44 dependent on the CB state information 72 from the CB device 2a, 2b, 2c.

The parameter terminal 5c enables a user to communicate with the POW controller 1, and it can exhibit in-/output functionality. Settings can be inputted/read out, e.g. by keyboard elements and/or display elements on the parameter terminal 5c and/or by computer interfaces at the parameter terminal 5c.

The point-on-wave controllers 1 according to the present invention can be implemented in single-phase or three-phase configurations. For three-phased configurations, operation strategies may be different for the three single phases, e.g. the calculated time delays 45 can be different for each phase and can be sent out individually to the three CB poles via the command output interface 7 depending on the calculated operation strategy for the corresponding CB devices.

For practical implementation, the point-on-wave controller 1 may be a lumped device that is installed in a specific location, or a distributed system where separate modules perform specific tasks. E.g. in a distributed system, a monitoring module may acquire and pre-process the monitoring signals 51a, 51b, a separate control unit module may perform the calculations, and a separate circuit breaker control module may send the actual control command 71 to the circuit breaker 2a; the modules may communicate with each other via digital communication interfaces. For the purpose of the present invention, such distributed arrangements are subsumed under the point-on-wave controller 1.

Advantages of the POW controller 1 according to the present invention are that no cost-intensive external circuitry (that may fail) is needed to select appropriate monitoring signal 51a, 51b defining operating parameters 49 of the power transmission network 3. Furthermore, by transmitting at least three monitoring signal 51a, 51b to the POW controller 1, more information is gathered about the operating parameters 49 of the power transmission network 3 and a better operation strategy for the CB device 2a, 2b, 2c can be calculated based on that plurality of monitoring signals.

The term "binary" with regard to a two-state or on-off state system is used synonymous to "1-bit-digital" or simply "digital". Such binary information may be transmitted by a physical signal (e.g. voltage on or off) or encoded as data value in a digital communication interface.

The term "analog" with regard to signals and interfaces refers to information that may assume more than two values, usually more than ten. Analog information may be transmitted by a physical signal (e.g. instantaneous voltage value) or encoded as data value in a digital communication interface.

Additionally to the mentioned analog voltage monitoring interfaces, devices, and signals, there can also exist additional analog current monitoring interfaces, devices, and signals to measure currents as part of the operating parameters of the power transmission network. These analog current monitoring interfaces, devices, and signals do not contribute to (i.e. are not counted as) the claimed numbers of monitoring interfaces, devices, and signals here.

In contrast to prior art POW controllers, the POW controller provided here utilizes the information from three monitoring signals from different locations in the power transmission network (with at least one of these monitoring signals being an analog voltage monitoring signal) to calculate a good operation strategy for the CB device. As stated above, optional analog current monitoring signals are not counted here.

### Reference numbers

1: Point-on-wave controller
2a, 2b, 2c: circuit breaker device
3: power transmission network
4: command input interface
5a, 5b, 5c: parameter input interface
5a, 5b: monitoring interfaces
5a: analog monitoring interface
5b: digital monitoring interface
5c: parameter terminal
6: control unit
6a: memory of control unit
6b: CPU of control unit
7: command output interface
40: switching command issuing device
41: external switching command
42: random time of external switching command
43: actual switching instant of CB device
44: CB operating time
45: calculated time delay
46: desired switching instant of CB device
47a, 47b, 47c: zero crossings
48a, 48b: positive peaks
49: operating parameters
50a, 50b: monitoring devices
51a, 51b: monitoring signals
52a, 52b: negative peaks
71: circuit breaker switching command
72: CB state information
93a, 93b, 93c, 93d: additional switches, e.g. asynchronously operated switches
94: capacitor
95: reactor
96: power transformer
97: transmission line
98a, 98b: bus bars
A, B: locations
99: logic circuit

## Claims

1. Point-on-wave controller (1) for network-synchronous operation of a circuit breaker device (2a, 2b, 2c), in particular in an AC high-voltage power transmission network (3), comprising a command input interface (4), a parameter input interface (5a, 5b, 5c), a control unit (6), and a command output interface (7), wherein
said command input interface (4) is adapted to be connected to a switching command issuing device (40) and to receive an external switching command (41) from said switching command issuing device (40),
said parameter input interface (5a, 5b, 5c) comprises at least three monitoring interfaces (5a, 5b) to said power transmission network (3) with at least one analog monitoring interface (5a) adapted to measure a voltage in said power transmission network (3),
said monitoring interfaces (5a, 5b) are adapted to be connected to monitoring devices (50a, 50b) in said power transmission network (3) and to monitor a plurality of operating parameters (49) of said power transmission network (3) via monitoring signals (51a, 51b) from said monitoring devices (50a, 50b), wherein said monitoring signals (51a, 51b) comprise at least one analog monitoring signal (51a) indicative of a voltage in said power transmission network (3), and wherein said connected monitoring devices (50a, 50b) are arranged at separate locations in a single-line diagram of said power transmission network (3),
said command output interface (7) is adapted to be connected to said circuit breaker device (2a, 2b, 2c) in said power transmission network (3) and to issue a circuit breaker switching command (71) to said circuit breaker device (2a, 2b, 2c), and
said control unit (6) is connected to said command input interface (4), said parameter input interface (5a, 5b, 5c), and said command output interface (7), and wherein said control unit (6) is adapted to calculate or select an operation strategy for said circuit breaker device (2a, 2b, 2c) based on said operating parameters (49) of said power transmission network (3), **characterized in that** said parameter input interface (5a, 5b, 5c) further comprises at least one digital monitoring interface (5b) adapted to measure a binary state of at least one additional switch (93a, 93b, 93c, 93d) in said power transmission network (3), which additional switch (93a, 93b, 93c, 93d) is different from the circuit breaker device (2a, 2b, 2c), and wherein said monitoring signals (51a, 51b) further comprise at least one digital monitoring signal (51b) indicative of said binary state of said additional switch (93a, 93b, 93c, 93d), wherein the binary state is indicative of a configuration in the power transmission network (3) wherein the configuration in the power transmission network is a current configuration of a load.

2. Point-on-wave controller (1) of claim 1, wherein the configuration in the power transmission network is a current configuration of a power transformer (96) or of a transmission line (97) or a grounding state of a neutral point of a reactor (95).

3. Point-on-wave controller (1) of claim 1 or 2, wherein the at least one additional switch (93a, 93b, 93c, 93d) is positioned on a load side and/or on a source side of the circuit breaker device (2a, 2b, 2c); and/or wherein a or the reference voltage sensor (50a) for point-on-wave controlled switching of the circuit breaker device (2a) is not permanently connected to the circuit breaker device (2a).

4. Point-on-wave controller (1) of any of the preceding claims, wherein the binary state of said additional switch (93a, 93b, 93c, 93d) is used to determine a network topology on a load side and/or source side of the circuit breaker device (2a, 2b, 2c), and/or is used to select at least one voltage sensor (50a) to be useful as a reference voltage sensor (50a) for point-on-wave controlled switching of the circuit breaker device (2a).

5. Point-on-wave controller (1) of any of the preceding claims, wherein the additional switch is a switch (93a) for connecting and disconnecting a shunt reactor (95) to the transmission line (97).

6. Point-on-wave controller (1) of any of the preceding claims, wherein the additional switch is a switch (93b, 93c) for connecting and disconnecting a neutral point of a three-phase primary device (95, 96), in particular the reactor (95) and/or the transformer (96), to earth.

7. Point-on-wave controller (1) of any of the preceding claims, wherein the additional switch is a switch (93a, 93b, 93c, 93d) for connecting and disconnecting a voltage sensor (50a) to a source side of the circuit breaker (2a), in particular to a busbar (98a, 98b), for determining whether the signal from said voltage sensor (50a) is indicative of a voltage applied to the circuit breaker device (2a).

8. Point-on-wave controller (1) of any of the preceding claims, wherein said parameter input interface (5a, 5b, 5c) comprises at least two analog monitoring interfaces (5a) and at least one digital monitoring interface (5b) to said power transmission network (3) for monitoring at least two voltages and at least one binary state as part of said operating parameters (49) of said power transmission network (3).

9. Point-on-wave controller (1) of claim 8, wherein said parameter input interface (5a, 5b, 5c) comprises exactly two analog monitoring interfaces (5a) and at least one digital monitoring interface (5b) to said power transmission network (3) for monitoring two voltages and at least one binary state as part of said operating parameters (49) of said power transmission network (3).

10. Point-on-wave controller (1) of claim 8 or 9, wherein the two voltages are used to determine a source side and a load side of the circuit breaker device (2a), and the digital monitoring signal (51b) indicative of said binary state of the additional switch (93a, 93b) on the load side is used to calculate or select the operation strategy of said circuit breaker device (2a).

11. Point-on-wave controller (1) of any of the preceding claims, wherein said parameter input interface (5a, 5b, 5c) comprises at least one analog monitoring interface (5a) and at least two digital monitoring interfaces (5b) to said power transmission network (3) for monitoring at least one voltage and at least two binary states as part of said operating parameters (49) of said power transmission network (3).

12. Point-on-wave controller (1) of any of the preceding claims, wherein said parameter input interface (5a, 5b, 5c) comprises at least three analog monitoring interfaces (5a) to said power transmission network (3) for monitoring at least three voltages as part of said operating parameters (49) of said power transmission network (3).

13. Point-on-wave controller (1) of any of the preceding claims, wherein said operating parameters (49) further comprise CB state information (72) about said circuit breaker device (2a, 2b, 2c).

14. Point-on-wave controller (1) of any of the preceding claims, wherein said operating parameters (49) are monitored continuously to calculate an operation strategy for said circuit breaker device (2a, 2b, 2c).

15. Point-on-wave controller (1) of any of the preceding claims, wherein said operating parameters (49) are monitored at a fixed update rate to calculate an operation strategy for said circuit breaker device (2a, 2b, 2c).

16. Point-on-wave controller (1) of any of the preceding claims, wherein prototypes of said operation strategy for different combinations of said operating parameters (49) are stored in a memory (6a) in said control unit (6) of said point-on-wave controller (1).

17. Point-on-wave controller (1) of any of the preceding claims, wherein said calculation of said operation strategy comprises a selection of at least one operating parameter (49), in particular an analog monitoring signal (51a), of said power transmission network (3) which is used as a reference signal for operation of said circuit breaker device (2a, 2b, 2c).

18. A method for network-synchronous operation of a circuit breaker device (2a, 2b, 2c) by means of a point-on-wave controller (1) of any of the preceding claims, comprising the steps of
receiving said external switching command (41) from said switching command issuing device (40) through said command input interface (4),
using sad control unit (6) to calculate said operation strategy for said circuit breaker device (2a, 2b, 2c) in said power transmission network (3) based on said operating parameters (49) of said power transmission network (3),
issuing said circuit breaker switching command (71) to said circuit breaker device (2a, 2b, 2c) through said command output interface (7).

19. The method of claim 18, further comprising the step of delaying said circuit breaker switching command (71) by a calculated time delay (45) dependent on said calculated operation strategy for said circuit breaker device (2a, 2b, 2c).

20. The method of claim 19, further comprising the step of adapting the calculated time delay (45) depending on CB state information (72) about said circuit breaker device (2a, 2b, 2c), wherein said CB state information (72) is part of said operating parameters (49) of said power transmission network (3).

21. Bay in a power transmission network (3) comprising at least one circuit breaker device (2a, 2b, 2c), at least one switching command issuing device (40), a plurality of monitoring devices (50a, 50b), and at least one point-on-wave controller (1) of any of the claims 1-17.

## Patentansprüche

1. Synchron-Steuergerät (1) für netzsynchronen Betrieb eines Leistungsschaltergeräts (2a, 2b, 2c), insbesondere in einem Hochspannungs-Wechselstrom-Übertragungsnetz (3), aufweisend eine Befehls-eingabe-Schnittstelle (4), eine Parametereingabe-Schnittstelle (5a, 5b, 5c), eine Steuervorrichtung (6) und eine Befehlsausgabe-Schnittstelle (7), wobei
die Befehlseingabe-Schnittstelle (4) angepasst ist, um an ein Schaltbefehl-Ausgabegerät (40) angeschlossen zu werden und um einen externen Schaltbefehl (41) vom Schaltbefehl-Ausgabegerät (40) zu empfangen,
wobei die Parametereingabe-Schnittstelle (5a, 5b, 5c) mindestens drei Überwachungsschnittstellen (5a, 5b) zum Energieübertragungsnetz (3) mit mindestens einer analogen Überwachungsschnittstelle (5a) zum Messen einer Spannung im Energieübertragungsnetz (3) aufweist,
wobei die Überwachungsschnittstellen (5a, 5b) angepasst sind, um an Überwachungsgeräte (50a, 50b) im Energieübertragungsnetz (3) angeschlossen zu werden und um mehrere Betriebsparameter (49) des Energieübertragungsnetzes (3) über Überwachungssignale (51a, 51b) von den Überwachungsgeräten (50a, 50b) zu überwachen, wobei die Überwachungssignale (51a, 51b) mindestens ein eine Spannung im Energieübertragungsnetz (3) anzeigendes, analoges Überwachungssignal (51a) aufweist, und wobei die angeschlossenen Überwachungsgeräte (50a, 50b) an getrennten Stellen in einem Einliniendiagramm des Energieübertragungsnetzes (3) angeordnet sind, wobei die Ausgabe-Schnittstelle (7) angepasst ist, um an das Leistungsschaltergerät (2a, 2b, 2c) im Energieübertragungsnetz (3) angeschlossen zu werden, und um einen Leistungsschalter-Schaltbefehl (71) an das Leistungsschaltergerät (2a, 2b, 2c) auszugeben, und
wobei die Steuervorrichtung (6) an die Befehlseingabe-Schnittstelle (4), die Parametereingabe-Schnittstelle (5a, 5b, 5c) und die Befehlsausgabe-Schnittstelle (7) angeschlossen ist, und wobei die Steuervorrichtung (6) angepasst ist zum Berechnen oder Auswählen einer Betriebsstrategie für das Leistungsschaltergerät (2a, 2b, 2c) auf Basis der Betriebsparameter (49) des Energieübertragungsnetzes (3), **dadurch gekennzeichnet, dass** die Parametereingabe-Schnittstelle (5a, 5b, 5c) ferner mindestens eine digitale Überwachungs-Schnittstelle (5b) aufweist, die angepasst ist für ein Messen eines binären Zustands mindestens eines zusätzlichen Schalters (93a, 93b, 93c, 93d) im Energieübertragungsnetz (3), wobei der zusätzliche Schalter (93a, 93b, 93c, 93d) sich vom Leistungsschaltergerät (2a, 2b, 2c) unterscheidet, und wobei die Überwachungssignale (51a, 51b) ferner mindestens ein, den binären Zustand des zusätzlichen Schalters (93a, 93b, 93c, 93d) anzeigendes digitales Überwachungssignal (51b) aufweisen, wobei der binäre Zustand indikativ für eine Konfiguration im Energieübertragungsnetz (3) ist, wobei die Konfiguration im Energieübertragungsnetz eine aktuelle Konfiguration einer Last ist.

2. Synchron-Steuergerät (1) nach Anspruch 1, wobei die Konfiguration im Energieübertragungsnetz eine aktuelle Konfiguration eines Leistungstransformators (96) oder einer Übertragungsleitung (97) oder ein Erdungszustand eines Sternpunkts eines Reaktors (95) ist.

3. Synchron-Steuergerät (1) nach Anspruch 1 oder 2, wobei der mindestens eine zusätzliche Schalter (93a, 93b, 93c, 93d) auf einer Lastseite und/oder auf einer Quellenseite des Leistungsschaltergeräts (2a, 2b, 2c) angeordnet ist und/oder wobei ein oder der Referenzspannungssensor (50a) für Point-on-Wave-gesteuertes Schalten des Leistungsschaltergeräts (2a) nicht dauerhaft an das Leistungsschaltergerät (2a) angeschlossen ist.

4. Synchron-Steuergerät (1) nach einem der vorhergehenden Ansprüche, wobei der binäre Zustand des zusätzlichen Schalters (93a, 93b, 93c, 93d) zum Bestimmen einer Netzwerktopologie auf einer Lastseite und/oder Quellenseite des Leistungsschaltergeräts (2a, 2b, 2c) benutzt wird und/oder zum Auswählen mindestens eines Spannungssensors (50a), um als ein Referenzspannungssensor (50a) für Point-on-Wave-gesteuertes Schalten des Leistungsschaltergeräts (2a) anwendbar zu sein.

5. Synchron-Steuergerät (1) nach einem der vorhergehenden Ansprüche, wobei der zusätzliche Schalter ein Schalter (93a) ist zum Verbinden und Trennen einer Nebenschlussdrossel (95) mit bzw. von der Übertragungsleitung (97).

6. Synchron-Steuergerät (1) nach einem der vorhergehenden Ansprüche, wobei der zusätzliche Schalter ein Schalter (93b, 93c) ist zum Verbinden und Trennen eines Sternpunkts eines Dreiphasen-Primärgeräts (95, 96), insbesondere des Reaktors (95) und/oder des Transformators (96) mit bzw. von Erde.

7. Synchron-Steuergerät (1) nach einem der vorhergehenden Ansprüche, wobei der zusätzliche Schalter ein Schalter (93a, 93b, 93c, 93d) ist zum Verbinden eines Spannungssensors mit bzw. Trennen eines Spannungssensors von einer Quellenseite des Leistungsschaltergeräts (2a), insbesondere an eine bzw. von einer Sammelschiene (98a, 98b) zum Bestimmen, ob das Signal vom Spannungssensor (50a) indikativ für eine am Leistungsschaltergerät (2a) angelegte Spannung ist.

8. Synchron-Steuergerät (1) nach einem der vorhergehenden Ansprüche, wobei die Parametereingabe-Schnittstelle (5a, 5b, 5c) mindestens zwei analoge Überwachungs-Schnittstellen (5a) und mindestens eine digitale Überwachungs-Schnittstelle (5b) zum Energieübertragungsnetz (3) zum Überwachen mindestens eines binären Zustands als Teil der Betriebsparameter (49) des Energieübertragungsnetzes (3) aufweist.

9. Synchron-Steuergerät (1) nach Anspruch 8, wobei die Parametereingabe-Schnittstelle (5a, 5b, 5c) genau zwei analoge Überwachungs-Schnittstellen (5a) und mindestens eine digitale Überwachungs-Schnittstelle (5b) zum Energieübertragungsnetz (3) zum Überwachen von zwei Spannungen und mindestens eines binären Zustands als Teil der Betriebsparameter (49) des Energieübertragungsnetzes (3) aufweist.

10. Synchron-Steuergerät (1) nach Anspruch 8 oder 9, wobei die zwei Spannungen zum Bestimmen einer Quellenseite und einer Lastseite des Leistungsschaltergeräts (2a) benutzt werden und das digitale Überwachungssignal (51b), das indikativ für den binären Zustand des zusätzlichen Schalters (93a, 93b) auf der Lastseite ist, für ein Berechnen oder Auswählen der Betriebsstrategie des Leistungsschaltergeräts (2a) benutzt wird.

11. Synchron-Steuergerät (1) nach einem der vorhergehenden Ansprüche, wobei die Parametereingabe-Schnittstelle (5a, 5b, 5c) mindestens eine analoge Überwachungs-Schnittstelle (5a) und mindestens zwei digitale Überwachungs-Schnittstellen (5b) zum Energieübertragungsnetz (3) zum Überwachen mindestens einer Spannung und von mindestens zwei binären Zuständen als Teil der Betriebsparameter (49) des Energieübertragungsnetzes (3) aufweist.

12. Synchron-Steuergerät (1) nach einem der vorhergehenden Ansprüche, wobei die Parametereingabe-Schnittstelle (5a, 5b, 5c) mindestens drei analoge Überwachungs-Schnittstellen (5a) zum Energieübertragungsnetz (3) zum Überwachen von mindestens drei Spannungen als Teil der Betriebsparameter (49) des Energieübertragungsnetzes (3) aufweist.

13. Synchron-Steuergerät (1) nach einem der vorhergehenden Ansprüche, wobei die Betriebsparameter (49) ferner CB-Statusinformation (72) über das Leistungsschaltergerät (2a, 2b, 2c) aufweisen.

14. Synchron-Steuergerät (1) nach einem der vorhergehenden Ansprüche, wobei die Betriebsparameter (49) kontinuierlich überwacht werden, um eine Betriebsstrategie für das Leistungsschaltergerät (2a, 2b, 2c) zu berechnen.

15. Synchron-Steuergerät (1) nach einem der vorhergehenden Ansprüche, wobei die Betriebsparameter (49) mit einer festen Aktualisierungsrate überwacht werden, um eine Betriebsstrategie für das Leistungsschaltergerät (2a, 2b, 2c) zu berechnen.

16. Synchron-Steuergerät (1) nach einem der vorhergehenden Ansprüche, wobei Prototypen der Betriebsstrategien für verschiedene Kombinationen der Betriebsparameter (49) in einem Speicher (6a) in der Steuervorrichtung (6) des Synchron-Steuergeräts (1) gespeichert werden.

17. Synchron-Steuergerät (1) nach einem der vorhergehenden Ansprüche, wobei das Berechnen der Betriebsstrategie eine Auswahl von mindestens einem Betriebsparameter (49), insbesondere eines analogen Überwachungssignals (51a) des Energieübertragungsnetzes (3), aufweist, das als ein Referenzsignal für den Betrieb des Leistungsschaltergeräts (2a, 2b, 2c) benutzt wird.

18. Verfahren zum netzsynchronen Betrieb eines Leistungsschaltergeräts (2a, 2b, 2c) mithilfe eines Synchron-Steuergeräts (1) nach einem der vorhergehenden Ansprüche, aufweisend die folgenden Schritte:
Empfangen eines externen Schaltbefehls (41) vom Schaltbefehl-Ausgabegerät (40) über die Befehlseingabe-Schnittstelle (4),
Verwenden der Steuervorrichtung (6) zum Berechnen der Betriebsstrategie für das Leistungsschaltergerät (2a, 2b, 2c) im Energieübertragungsnetz (3) auf Basis der Betriebsparameter (49) des Energieübertragungsnetzes (3),
Ausgeben des Leistungsschalter-Schaltbefehls (71) an das Leistungsschaltergerät (2a, 2b, 2c) über die Befehlsausgabe-Schnittstelle (7).

19. Verfahren nach Anspruch 18, ferner aufweisend den Schritt des Verzögerns des Leistungsschalter-Schaltbefehls (71) um eine berechnete 2eitverzögerung (45) in Abhängigkeit von der berechneten Betriebsstrategie für das Leistungsschaltergerät (2a, 2b, 2c).

20. Verfahren nach Anspruch 19, ferner aufweisend den Schritt des Anpassens der berechneten Zeitverzögerung (45) in Abhängigkeit von der CB-Statusinformation (72) über das Leistungsschaltergerät (2a, 2b, 2c), wobei die CB-Statusinformation (72) Teil der Betriebsparameter (49) des Energieübertragungsnetzes (3) ist.

21. Schaltfeld in einem Energieübertragungsnetz (3), aufweisend mindestens ein Leistungsschaltergerät (2a, 2b, 2c), mindestens ein Schaltbefehl-Ausgabegerät (40), mehrere Überwachungsvorrichtungen (50a, 50b) und mindestens ein Synchron-Steuergerät (1) nach einem der Ansprüche 1 bis 17.

## Revendications

1. Contrôleur sur un point de l'onde (1) permettant un fonctionnement synchrone sur réseau d'un dispositif disjoncteur (2a, 2b, 2c), notamment dans un réseau de transport d'énergie en courant alternatif à haute tension (3), comprenant une interface d'entrée de commandes (4), une interface d'entrée de paramètres (5a, 5b, 5c), une unité de commande (6) et une interface de sortie de commandes (7), dans lequel
ladite interface d'entrée de commandes (4) est adaptée à être raccordée à un dispositif de délivrance de commandes de commutation (40) et à recevoir une commande de commutation externe (41) issue dudit dispositif de délivrance de commandes de commutation (40),
ladite interface d'entrée de paramètres (5a, 5b, 5c) comprend au moins trois interfaces de contrôle (5a, 5b) avec ledit réseau de transport d'énergie (3), au moins une interface de contrôle analogique (5a) étant adaptée à mesurer une tension dans ledit réseau de transport d'énergie (3),
lesdites interfaces de contrôle (5a, 5b) sont adaptées à être raccordées à des dispositifs de contrôle (50a, 50b) dans ledit réseau de transport d'énergie (3) et à contrôler une pluralité de paramètres de fonctionnement (49) dudit réseau de transport d'énergie (3) au moyen de signaux de contrôle (51a, 51b) issus desdits dispositifs de contrôle (50a, 50b), lesquels signaux de contrôle (51a, 51b) comprennent au moins un signal de contrôle analogique (51a) indiquant une tension dans ledit réseau de transport d'énergie (3), et lesquels dispositifs de contrôle (50a, 50b) raccordés occupent des emplacements distincts dans un schéma unifilaire dudit réseau de transport d'énergie (3),
ladite interface de sortie de commandes (7) est adaptée à être raccordée audit dispositif disjoncteur (2a, 2b, 2c) dans ledit réseau de transport d'énergie (3) et à délivrer une commande de commutation de disjoncteur (71) audit dispositif disjoncteur (2a, 2b, 2c), et
ladite unité de commande (6) est raccordée à ladite interface d'entrée de commandes (4), à ladite interface d'entrée de paramètres (5a, 5b, 5c) et à ladite interface de sortie de commandes (7), et ladite unité de commande (6) est adaptée à calculer ou à sélectionner une stratégie de fonctionnement pour ledit dispositif disjoncteur (2a, 2b, 2c) en fonction desdits paramètres de fonctionnement (49) dudit réseau de transport d'énergie (3), **caractérisé en ce que** ladite interface d'entrée de paramètres (5a, 5b, 5c) comprend en outre au moins une interface de contrôle numérique (5b) adaptée à mesurer un état binaire d'au moins un commutateur supplémentaire (93a, 93b, 93c, 93d) dans ledit réseau de transport d'énergie (3), lequel commutateur supplémentaire (93a, 93b, 93c, 93d) est différent du dispositif disjoncteur (2a, 2b, 2c), et dans lequel lesdits signaux de contrôle (51a, 51b) comprennent en outre au moins un signal de contrôle numérique (51b) indiquant ledit état binaire dudit commutateur supplémentaire (93a, 93b, 93c, 93d), lequel état binaire indique une configuration dans le réseau de transport d'énergie (3), laquelle configuration dans le réseau de transport d'énergie est une configuration actuelle d'une charge.

2. Contrôleur sur un point de l'onde (1) selon la revendication 1, dans lequel la configuration dans le réseau de transport d'énergie est une configuration actuelle d'un transformateur de puissance (96) ou d'une ligne de transport (97) ou un état de mise à la terre d'un point neutre d'une bobine d'inductance (95).

3. Contrôleur sur un point de l'onde (1) selon la revendication 1 ou 2, dans lequel ledit au moins un commutateur supplémentaire (93a, 93b, 93c, 93d) est placé d'un côté charge et/ou d'un côté source du dispositif disjoncteur (2a, 2b, 2c) ; et/ou dans lequel un ou le capteur de tension de référence (50a) pour la commutation du dispositif disjoncteur (2a) commandée sur un point de l'onde n'est pas raccordé de façon permanente au dispositif disjoncteur (2a).

4. Contrôleur sur un point de l'onde (1) selon l'une quelconque des revendications précédentes, dans lequel l'état binaire dudit commutateur supplémentaire (93a, 93b, 93c, 93d) sert à déterminer une topologie de réseau d'un côté charge et/ou d'un côté source du dispositif disjoncteur (2a, 2b, 2c), et/ou sert à sélectionner au moins un capteur de tension (50a) destiné à servir de capteur de tension de référence (50a) pour la commutation du dispositif disjoncteur (2a) commandée sur un point de l'onde.

5. Contrôleur sur un point de l'onde (1) selon l'une quelconque des revendications précédentes, dans lequel le commutateur supplémentaire est un commutateur (93a) permettant de raccorder une bobine d'inductance shunt (95) à la ligne de transport (97) et à l'en déconnecter.

6. Contrôleur sur un point de l'onde (1) selon l'une quelconque des revendications précédentes, dans lequel le commutateur supplémentaire est un commutateur (93b, 93c) permettant de raccorder un point neutre d'un dispositif primaire triphasé (95, 96), plus particulièrement de la bobine d'inductance (95) et/ou du transformateur (96), à la terre et à l'en déconnecter.

7. Contrôleur sur un point de l'onde (1) selon l'une quelconque des revendications précédentes, dans lequel le commutateur supplémentaire est un commutateur (93a, 93b, 93c, 93d) permettant de raccorder un capteur de tension (50a) à un côté source du dispositif disjoncteur (2a), plus particulièrement à une barre bus (98a, 98b), et à l'en déconnecter pour déterminer si le signal issu dudit capteur de tension (50a) indique une tension appliquée au dispositif disjoncteur (2a).

8. Contrôleur sur un point de l'onde (1) selon l'une quelconque des revendications précédentes, dans lequel ladite interface d'entrée de paramètres (5a, 5b, 5c) comprend au moins deux interfaces de contrôle analogiques (5a) et au moins une interface de contrôle numérique (5b) avec ledit réseau de transport d'énergie (3) permettant de contrôler au moins deux tensions et au moins un état binaire au titre desdits paramètres de fonctionnement (49) dudit réseau de transport d'énergie (3).

9. Contrôleur sur un point de l'onde (1) selon la revendication 8, dans lequel ladite interface d'entrée de paramètres (5a, 5b, 5c) comprend exactement deux interfaces de contrôle analogiques (5a) et au moins une interface de contrôle numérique (5b) avec ledit réseau de transport d'énergie (3) permettant de contrôler deux tensions et au moins un état binaire au titre desdits paramètres de fonctionnement (49) dudit réseau de transport d'énergie (3).

10. Contrôleur sur un point de l'onde (1) selon la revendication 8 ou 9, dans lequel les deux tensions servent à déterminer un côté source et un côté charge du dispositif disjoncteur (2a), et le signal de contrôle numérique (51b) indiquant ledit état binaire du commutateur supplémentaire (93a, 93b) du côté charge sert à calculer ou à sélectionner la stratégie de fonctionnement dudit dispositif disjoncteur (2a).

11. Contrôleur sur un point de l'onde (1) selon l'une quelconque des revendications précédentes, dans lequel ladite interface d'entrée de paramètres (5a, 5b, 5c) comprend au moins une interface de contrôle analogique (5a) et au moins deux interfaces de contrôle numériques (5b) avec ledit réseau de transport d'énergie (3) permettant de contrôler au moins une tension et au moins deux états binaires au titre desdits paramètres de fonctionnement (49) dudit réseau de transport d'énergie (3).

12. Contrôleur sur un point de l'onde (1) selon l'une quelconque des revendications précédentes, dans lequel ladite interface d'entrée de paramètres (5a, 5b, 5c) comprend au moins trois interfaces de contrôle analogiques (5a) avec ledit réseau de transport d'énergie (3) permettant de contrôler au moins trois tensions au titre desdits paramètres de fonctionnement (49) dudit réseau de transport d'énergie (3).

13. Contrôleur sur un point de l'onde (1) selon l'une quelconque des revendications précédentes, dans lequel lesdits paramètres de fonctionnement (49) comprennent en outre des informations d'état de disjoncteur (72) concernant ledit dispositif disjoncteur (2a, 2b, 2c).

14. Contrôleur sur un point de l'onde (1) selon l'une quelconque des revendications précédentes, dans lequel lesdits paramètres de fonctionnement (49) sont contrôlés de façon continue aux fins de calculer une stratégie de fonctionnement pour ledit dispositif disjoncteur (2a, 2b, 2c).

15. Contrôleur sur un point de l'onde (1) selon l'une quelconque des revendications précédentes, dans lequel lesdits paramètres de fonctionnement (49) sont contrôlés à une fréquence de mise à jour fixe aux fins de calculer une stratégie de fonctionnement pour ledit dispositif disjoncteur (2a, 2b, 2c).

16. Contrôleur sur un point de l'onde (1) selon l'une quelconque des revendications précédentes, dans lequel des prototypes de ladite stratégie de fonctionnement pour différentes combinaisons desdits paramètres de fonctionnement (49) sont enregistrés dans une mémoire (6a) dans ladite unité de commande (6) dudit contrôleur sur un point de l'onde (1).

17. Contrôleur sur un point de l'onde (1) selon l'une quelconque des revendications précédentes, dans lequel ledit calcul de ladite stratégie de fonctionnement comprend une sélection d'au moins un paramètre de fonctionnement (49), plus particulièrement d'un signal de contrôle analogique (51a), dudit réseau de transport d'énergie (3) servant de signal de référence pour le fonctionnement dudit dispositif disjoncteur (2a, 2b, 2c).

18. Procédé permettant un fonctionnement synchrone sur réseau d'un dispositif disjoncteur (2a, 2b, 2c) au moyen d'un contrôleur sur un point de l'onde (1) selon l'une quelconque des revendications précédentes, le procédé comprenant les étapes consistant à :
recevoir ladite commande de commutation externe (41) issue dudit dispositif de délivrance de commandes de commutation (40) par le biais de ladite interface d'entrée de commandes (4),
utiliser ladite unité de commande (6) pour calculer ladite stratégie de fonctionnement pour ledit dispositif disjoncteur (2a, 2b, 2c) dans ledit réseau de transport d'énergie (3) en fonction desdits paramètres de fonctionnement (49) dudit réseau de transport d'énergie (3),
délivrer ladite commande de commutation de disjoncteur (71) audit dispositif disjoncteur (2a, 2b, 2c) par le biais de ladite interface de sortie de commandes (7).

19. Procédé selon la revendication 18, comprenant en outre l'étape consistant à temporiser ladite commande de commutation de disjoncteur (71) d'un délai de temporisation calculé (45) en fonction de ladite stratégie de fonctionnement calculée pour ledit dispositif disjoncteur (2a, 2b, 2c).

20. Procédé selon la revendication 19, comprenant en outre l'étape consistant à adapter le délai de temporisation calculé (45) en fonction d'informations d'état de disjoncteur (72) concernant ledit dispositif disjoncteur (2a, 2b, 2c), lesdites informations d'état de disjoncteur (72) faisant partie desdits paramètres de fonctionnement (49) dudit réseau de transport d'énergie (3).

21. Baie dans un réseau de transport d'énergie (3) comprenant au moins un dispositif disjoncteur (2a, 2b, 2c), au moins un dispositif de délivrance de commandes de commutation (40), une pluralité de dispositifs de contrôle (50a, 50b) et au moins un contrôleur sur un point de l'onde (1) selon l'une quelconque des revendications 1 à 17.
